# EUROPEAN PATENT SPECIFICATION

(11) **EP 1 333 498 B1**
(45) Date of publication and mention of the grant of the patent: **29.08.2007**
(21) Application number: 02021760.0
(22) Date of filing: 25.09.2002
(51) Int. Cl.: H01L 27/146, H01L 27/148

(54) **Solid state image sensor array for correcting curvilinear distortion of a camera lens system and method for fabricating the image sensor array**
Bildsensormatrix für zur Korrektion krummliniger Verzerrung eines Kamera-Linsensystems und dessen Verfahren zur Herstellung
Réseau de capteurs d'image pour la correction de la distorsion curviligne d'un système photographique de lentilles et sa procédé de fabrication

(30) Priority: 31.01.2002 US 62695
(43) Date of publication of application: 06.08.2003
(73) Proprietor: Agilent Technologies, Inc., Santa Clara, CA 95051 (US)
(72) Inventor: Gordon, Gary B., Saratoga, California 95070 (US)
(74) Representative: Schoppe, Fritz

(56) References cited:
- EP-A- 0 786 814
- EP-A- 1 239 519
- US-A1- 2002 009 901
- YOICHI SETO ET AL: "GEOMETRIC CORRECTION ALGORITHMS FOR SATELLITE IMAGERY USING A BI-DIRECTIONAL SCANNING SENSOR" IEEE TRANSACTIONS ON GEOSCIENCE AND REMOTE SENSING, IEEE INC. NEW YORK, US, vol. 29, no. 2, 1 March 1991 (1991-03-01), pages 292-298, XP000224121 ISSN: 0196-2892
- SUEMATU Y ET AL: "A wide angle vision sensor with fovea-design of distortion lens and the simulated images" INDUSTRIAL ELECTRONICS, CONTROL, AND INSTRUMENTATION, 1993. PROCEEDINGS OF THE IECON '93., INTERNATIONAL CONFERENCE ON MAUI, HI, USA 15-19 NOV. 1993, NEW YORK, NY, USA,IEEE, 15 November 1993 (1993-11-15), pages 1770-1773, XP010109289 ISBN: 0-7803-0891-3

## Description

### FIELD OF THE INVENTION

The invention relates generally to solid state image sensor arrays, and more particularly to a solid state image sensor array for correcting the curvilinear distortion of a camera lens system.

### BACKGROUND OF THE INVENTION

Digital imaging devices, such as digital cameras, use a lens system to focus an image onto a solid state image sensor array. The performance of such a lens system depends on a number of parameters, such as aperture size, field of depth, level of focus and amount of distortion. However, designers of lens systems are forced to make tradeoffs between these parameters and the cost of the lens system. As an example, reducing distortion below five to ten percent by adding a lens element to compensate for the distortion will typically increase the cost of the lens system by approximately twenty-five percent and decrease the aperture of the lens system. As a practical matter in cameras, a residual distortion of around two percent is considered tolerable, if not desirable.

Distortion of a lens system manifests as a geometric distortion on the captured image using that lens system. Common geometric distortions are "barrel" distortion and "pincushion" distortion. Barrel distortion causes straight lines to bow or bend in toward the edges of an image, and thus, an image with barrel distortion resembles the convex surface of a barrel. Pincushion distortion is the inverse of the barrel distortion. Pincushion distortion causes straight lines to bow in toward the middle of an image, and thus, an image with pincushion distortion resembles the surface of a pincushion.

There are several conventional approaches to correct the barrel or pincushion distortions on images without adding an additional lens element to the lens system. One approach is to correct the barrel or pincushion distortions on images after the images have been captured. In this approach, an image processing algorithm is applied to the captured images to digitally manipulate the images to compensate for the barrel or pincushion distortions. A concern with the image processing solution is that complex computations need to be performed to correct these distortions, which may require a powerful and expensive processor in the digital imaging system, and may unduly delay the overall image capturing process.

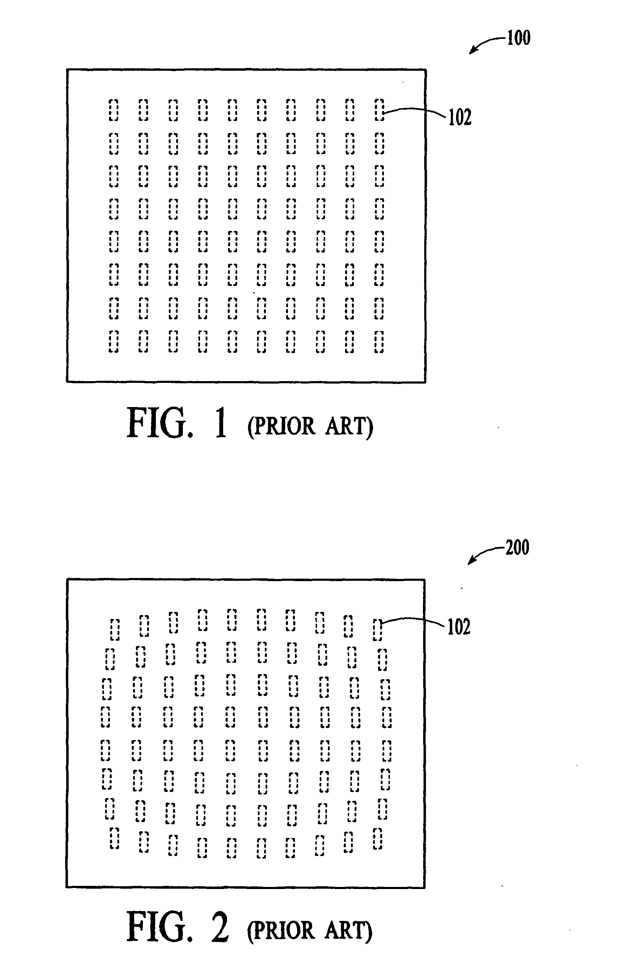

Another conventional approach to correct the barrel or pincushion distortions on images is to modify the solid state image sensor array used to capture the images. As illustrated in Fig. 1, a typical solid state image sensor array 100 includes photosensitive elements 102, such as photodiodes, that are distributed in a uniform pattern. That is, the distance between any horizontally adjacent photosensitive elements is the same. Similarly, the distance between any vertically adjacent photosensitive elements is the same. The image sensor array 100 is not designed to compensate for the distortion of a lens system (not shown), which causes the barrel or pincushion distortions in captured images. However, the image sensor array can be modified to compensate for the distortion of the lens system by positioning the photosensitive elements of the image sensor array in a distribution pattern that takes into account for the distortion of the lens system. (see e.g. EP 0786 814 11)

In Fig. 2, a modified solid state image sensor array 200 that corrects barrel distortions in images is shown. The modified image sensor array is configured such that photosensitive elements 102 are distributed in a non-uniform pattern. The non-uniform pattern resembles the barrel distortion on images. The image signals generated from these photosensitive elements of the image sensor array 200 are then processed in the conventional manner. That is, the image signals are processed as if the signals are from photosensitive elements that are distributed in a uniform pattern. Consequently, the resulting image will have been corrected for the barrel distortion. Similar approach may also be used to correct for pincushion distortions.

A concern with the use of the modified image sensor array 200 to correct for curvilinear distortions is that the non-uniform distribution pattern of the photosensitive elements 102 may affect the surface area of the photosensitive elements, especially those positioned toward the edges of the image sensor array. Since the density of photosensitive elements needs to be increased toward the edges of the image sensor array, the photosensitive elements near the edges of the image sensor array may have to be smaller in surface size than the photosensitive elements near the center of the image sensor array. Consequently, the efficiency of the image sensor array may be reduced due to the non-uniform distribution of the photosensitive elements.

Another concern with the modified image sensor array 200 is that such an image sensor array may be difficult to fabricate. The non-uniform distribution of the photosensitive elements may require modification of straight elongated structures of the image sensor array, such as charge coupled device (CCD) channels or electrical connections, into jagged structures with sharp comers to accommodate the non-uniformly distributed photosensitive elements. Consequently, these jagged structures may present a challenge to fabricate the modified image sensor array using a conventional high volume fabrication process.

It is the object of the present invention to provide for a solid state image sensor array for correcting the curvilinear distortion of a camera lens system, which has increased efficiency and is suitable for high volume fabrication, and method for efficiently fabricating the image sensor array.

This object is achieved by an array of claim 1, and by a method of claim 6.

### SUMMARY OF THE INVENTION

A solid state image sensor array for correcting curvilinear distortion and method for fabricating the image sensor array utilizes straight line segments that approximate the curvature of the curvilinear distortion to define structures of the image sensor array. The use of these straight line segments results in photosensitive elements that are distributed in a non-uniform pattern to compensate for the curvilinear distortion, which may be barrel or pincushion distortion. In addition, the use of straight line segments increases the efficiency of the photosensitive elements by maximizing the surface area of the photosensitive elements. Furthermore, since the structures of the image sensor array are defined by the straight line segments, the design of the image sensor array is suitable for conventional high volume fabrication process.

A solid state image sensor array in accordance with the present invention includes an array of photosensitive elements. The photosensitive elements may be photodiodes or other elements that generate charge in response to impinging photons. The photosensitive elements are distributed in a non-uniform pattern that compensates for the curvilinear distortion caused by an associated lens system. The photosensitive elements are defined by particular areas of the image sensor array. Some of these areas that define the photosensitive elements have a non-perpendicular corner.

In some embodiments, some of the areas of the photosensitive elements are defined by curved line segments that correspond to the curvilinear distortion. In other embodiments, some of the photosensitive elements are defined by straight line segments that form polygonal areas. The polygonal areas may be quadrilateral areas. The orientations of the straight line segments that form the polygonal areas approximate the curvature of the curvilinear distortion.

The image sensor array may further include elongated structures, such as charge-coupled device channels or conductive strips, having edges that correspond to the curvature of the curvilinear distortion. In some embodiments, the edges of the elongated structures are defined by curved lines that correspond to the curvature of the curvilinear distortion. In other embodiments, the edges of the elongated structures are defined by multiple straight line segments that approximate the curvature of the curvilinear distortion.

A method of fabricating a solid state image sensor array designed to correct for a curvilinear distortion includes the steps of generating an original composite layout of the image sensor array that includes straight line segments that define structures of the image sensor array, transforming the original composite layout into a modified composite layout, which includes warping the straight line segments into curved lines segments that correspond to the curvature of the curvilinear distortion, and forming the structures of the image sensor array using the modified composite layout to fabricate the image sensor array.

The step of transforming the original composite layout into the modified composite layout includes converting the curved line segments of the structures into replacement straight line segments that approximate the orientations of the curved line segments.

In some embodiments, the step of converting the curved line segments into the replacement straight line segments involves converting some of the curved line segments into single straight line segments, which includes converting curved line segments that define photosensitive elements into sets of straight line segments that form polygonal areas, such as quadrilateral areas. The single straight line segments are orientated to conform to the converted curved line segments. Some of the polygonal areas formed by the straight line segments have a non-perpendicular corner.

In other embodiments, the step of converting the curved line segments into the replacement straight line segments involves converting some of the curved line segments into multiple straight line segments that substantially trace the converted curved line segments, which includes converting some of the curved line segments that define elongated structures of the image sensor array into sets of multiple straight line segments that trace the converted curved line segments. The elongated structures may include charge-coupled device channels or conductive strips.

Other aspects and advantages of the present invention will become apparent from the following detailed description, taken in conjunction with the accompanying drawings, illustrated by way of example of the principles of the invention.

### BRIEF DESCRIPTION OF THE DRAWINGS

Fig. 1 illustrates the layout of a conventional solid state image sensor array having photosensitive elements distributed in a uniform pattern.

Fig. 2 illustrates the layout of a conventional solid state image sensor array having photosensitive elements distributed in a non-uniform pattern to correct for the curvilinear distortion of an associated camera lens system.

Fig. 3 illustrates the layout of a charge-coupled device (CCD) image sensor array in accordance with a first exemplary embodiment of the present invention.

Fig. 4A illustrates a reference image without any distortion.

Fig. 4B illustrates a comparison image with barrel distortion.

Fig. 5 illustrates the layout of a CCD image sensor array in accordance with a second exemplary embodiment of the present invention.

Fig. 6 illustrates the difference between a CCD channel with curved edges that conform to the curvature of the curvilinear distortion and a CCD channel with multiple line segment edges that approximate the curvature of the curvilinear distortion.

Fig. 7 is process flow diagram of a method for fabricating the CCD image sensor array of Fig. 5 in accordance with the present invention.

Fig. 8 illustrates the manner in which a CCD channel can be converted from a warped feature defined by curved line segments to an approximated feature defined by multiple straight line segments.

Fig. 9 illustrates the layout of a complementary metal oxide semiconductor (CMOS) sensor array in accordance with an exemplary embodiment of the present invention.

### DETAILED DESCRIPTION

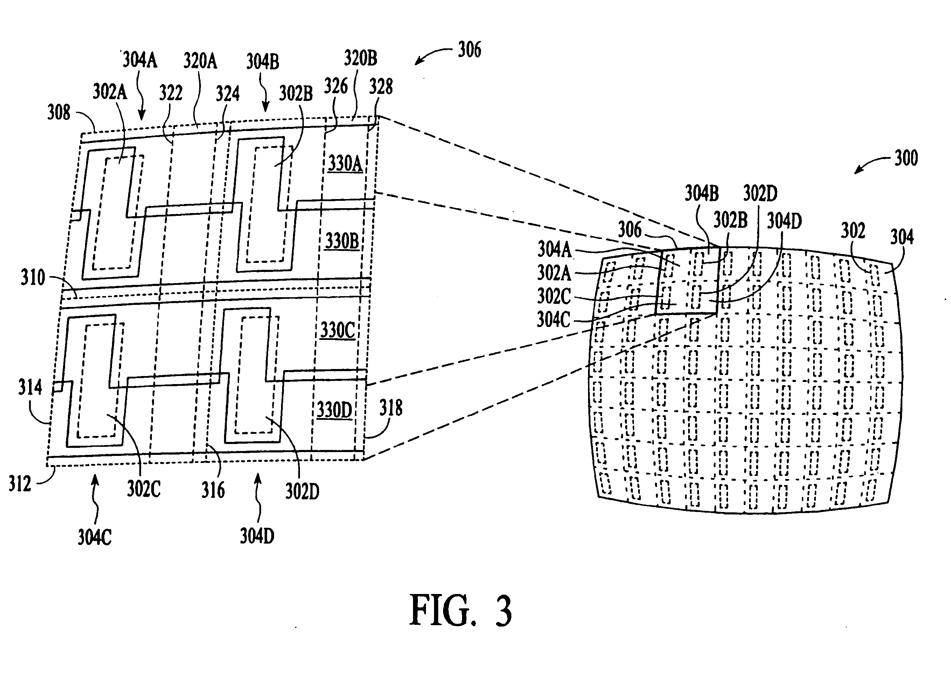

With reference to Fig. 3, a charge-coupled device (CCD) image sensor array 300 in accordance with a first exemplary embodiment the invention is shown. The CCD image sensor array is designed to correct for curvilinear distortion of an associated lens system (not shown). The image sensor array includes photosensitive elements 302 that are distributed in a non-uniform pattern to compensate for the curvilinear distortion of the lens system. The curvilinear distortion may cause "barrel" distortion, "pincushion" distortion or any other type of spatial distortion in images captured using the associated lens system. However, the image sensor array is illustrated and described herein as being designed to correct for curvilinear distortion that causes barrel distortion in images. The design of the CCD image sensor array improves the efficiency of the photosensitive elements by maximizing the surface areas of the photosensitive elements, especially those photosensitive elements that are significantly reduced in size due to the non-uniform distribution of the photosensitive elements.

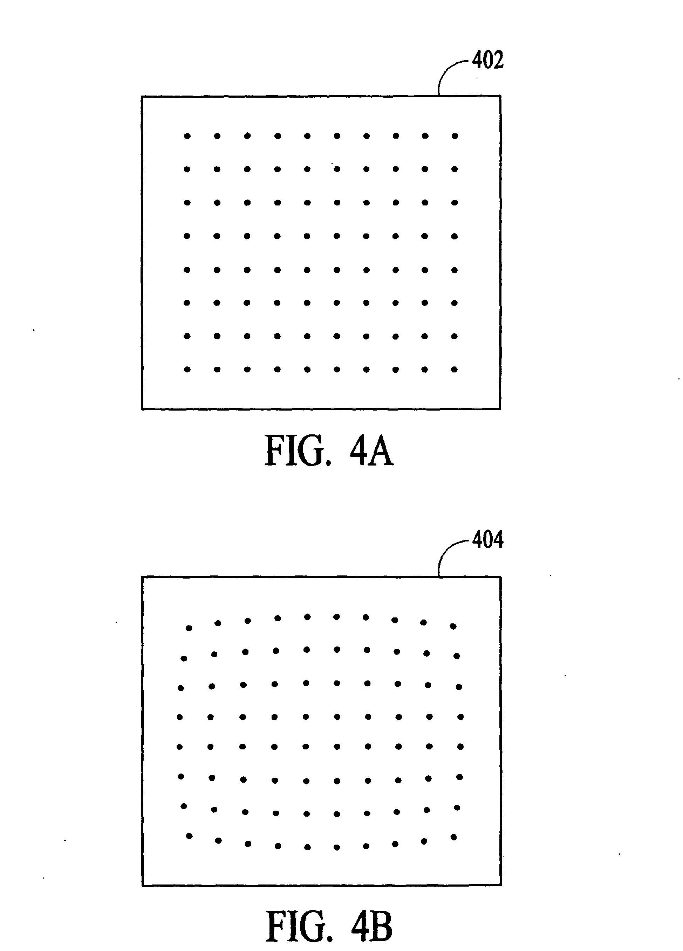

The effects of barrel distortion can be shown by comparing a reference image 402 without any distortion to a comparison image 404 with barrel distortion, which are shown in Figs. 4A and 4B. The reference image includes dots that are distributed throughout the image. The comparison image includes corresponding dots that are also distributed throughout the image. In the reference image, the dots are distributed uniformly throughout the image. That is, the distance between any adjacent dots of the reference image is the same. In the comparison image, the dots are distributed non-uniformly throughout the image. That is, the distance between adjacent dots of the comparison image vary depending on their position in the image. Due to the barrel distortion, the dots near the edges of the comparison image are closer together than the dots near the center of the comparison image. The dots of the reference and comparison images can be thought of as image pixels that form the images. An image pixel corresponds to a photosensitive element of the image sensor array that was used to capture the image.

Turning back to Fig. 3, the CCD image sensor array 300 includes a number of pixel regions 304. Each pixel region of the image sensor array includes a photosensitive element 302, or more precisely, a photodiode. The photosensitive elements are distributed throughout the image sensor array in a non-uniform pattern, similar to the non-uniform distribution of the dots of the comparison image 404 with barrel distortion in Fig. 4B and the non-uniform photosensitive element distribution of the modified solid state image sensor array 200 of Fig. 2. Consequently, the image sensor array 300 can be used to correct barrel distortions by processing image signals from the photosensitive elements 302 as if the signals are from photosensitive elements that are distributed in a conventional uniform pattern, as illustrated by the photosensitive elements 102 of the image sensor array 100 in Fig. 1. Each captured image signal corresponds to an individual image pixel that forms the captured image. Thus, when the captured image signals are processed, the resulting image pixels are positioned in a uniform pattern similar to the uniform distribution of the dots of the reference image 404 without any distortion in Fig. 4B, which compensates for the curvilinear distortion of the associated lens system.

The pixel regions 304 of the CCD image sensor array 300 are defined by curved lines that get closer to each other as these lines approach the edges of the image sensor array. The curved lines correspond to the curvature of the curvilinear distortion of the associated lens system. Consequently, the pixel regions of the image sensor array are not rectangular in shape, although the pixel regions in the center of the image sensor array are substantially rectangular. Due to the non-rectangular configuration of the pixel regions, the photosensitive elements of the image *sensor* array are distributed in the non-uniform pattern. As a result, the photosensitive elements are positioned to correct for the curvilinear distortion of the lens system.

In Fig. 3, a section 306 of the image sensor array 300 is shown enlarged to more clearly illustrate the configuration of the individual pixel regions 304 of the image sensor array. The enlarged section includes four exemplary pixel regions 304A, 304B, 304C and 304D of the image sensor array that are defined by horizontally orientated curved lines 308, 310 and 312, and vertically orientated curved lines 314, 316 and 318. The exemplary pixel regions 304A, 304B, 304C and 304D include photosensitive elements 302A, 302B, 302C and 302D, respectively.

The CCD image sensor array 300 includes vertically orientated CCD channels that carry accumulated charges from each column of photosensitive elements. Two exemplary CCD channels 320A and 320B are shown in the enlarged section 306 of the image sensor array. The CCD channels are defined by doped regions, which are formed by doping exposed areas of a semiconductor substrate during fabrication of the image sensor array. The CCD channels extend substantially vertical across the image sensor array. The vertically orientated edges of the CCD channels are curved in the same manner as the vertically orientated curved lines that define the pixel regions of the image sensor array. Thus, the vertically orientated edges of the CCD channels correspond to the curvature of the curvilinear distortion. At the pixel level, the vertically orientated edges of each CCD channel are virtually parallel to the nearest vertically orientated curved line that partially defines a column of pixel regions. Thus, the vertically orientated edges 322 and 324 of the CCD channel 320A are virtually parallel to the vertically orientated curved line 316, while the vertically orientated edges 326 and 328 of the CCD channel 320B are virtually parallel to the vertically orientated curved line 318.

The CCD image sensor array 300 further includes horizontally orientated electrodes that extend substantially horizontal across the image sensor array. Four exemplary horizontally orientated electrodes 330A, 330B, 330C and 330D are shown in the enlarged section 306 of the image sensor array. The horizontally orientated electrodes provide appropriate voltages to transfer accumulated charges from a row of photosensitive elements to corresponding vertically orientated CCD channels. Furthermore, the horizontally orientated electrodes provide appropriate voltages to vertically transfer the accumulated charges along the CCD channels. Similar to the vertically oriented edges of the CCD channels, the vertically and horizontally orientated edges of the electrodes are curved in the same manner as the vertically and horizontally orientated curved lines that define the pixel regions 304 of the image sensor array 300. At the pixel level, the vertically orientated edges of the electrodes are virtually parallel to the nearest vertically orientated curved line that partially defines a column of pixel regions. Similarly, the horizontally orientated edges of the electrodes are virtually parallel to the nearest horizontally orientated curved line that partially defines a row of pixel regions. Thus, in the enlarged section 306 of the image sensor array, the vertically orientated edges of the electrodes 330A, 330B, 330C and 330D are virtually parallel to the nearest curved line of the vertically orientated curved lines 314, 316 and 318, while the horizontally orientated edges of the electrodes are virtually parallel to the nearest curved line of the horizontally orientated curved lines 308, 310 and 312.

Similar to the CCD channels and the electrodes, the vertically and horizontally orientated edges of the photosensitive elements 302 of the image sensor array 300 are curved in the same manner as the vertically and horizontally orientated curved lines that define the pixel regions 304 of the image sensor array. Thus, the vertically and horizontally orientated edges of the photosensitive element within each pixel region of the image sensor array are virtually parallel to the vertically and horizontally orientated curved lines that define that pixel region. Consequently, the shape of a photosensitive element within a pixel region is substantially similar to the shape of that pixel region. Since the edges of the photosensitive elements are curved, the surface areas that define the photosensitive elements do not have perpendicular comers. The configuration of the photosensitive elements maximizes the surface area of the photosensitive elements, especially the photosensitive elements near the edges of the image sensor array. Thus, the efficiency of the image sensor array is greater than a comparable image sensor array with rectangular photosensitive elements.

The CCD image sensor array 300 further includes a light shield layer (not shown) that overlies the CCD channels and the electrodes. The light shield layer is patterned to expose only the photosensitive elements 302. Thus, the exposed areas of the light shield layer are shaped substantially similar to the photosensitive elements.

A concern with the CCD image sensor array 300 of Fig. 3 is that the curved edges of the photosensitive elements 302, the CCD channels and the electrodes are difficult to fabricate and thus, the image sensor array is not suitable for conventional high-volume semiconductor fabrication. In a conventional semiconductor fabrication process, masks created by a pattern generator are used to fabricate various components of semiconductor devices. However, a pattern generator typically uses rectangular shapes to form the patterns of masks. Consequently, masks with curved edges cannot be created using a conventional pattern generator. Thus, the layout of the CCD image sensor array 300 is not suitable for conventional high-volume fabrication process.

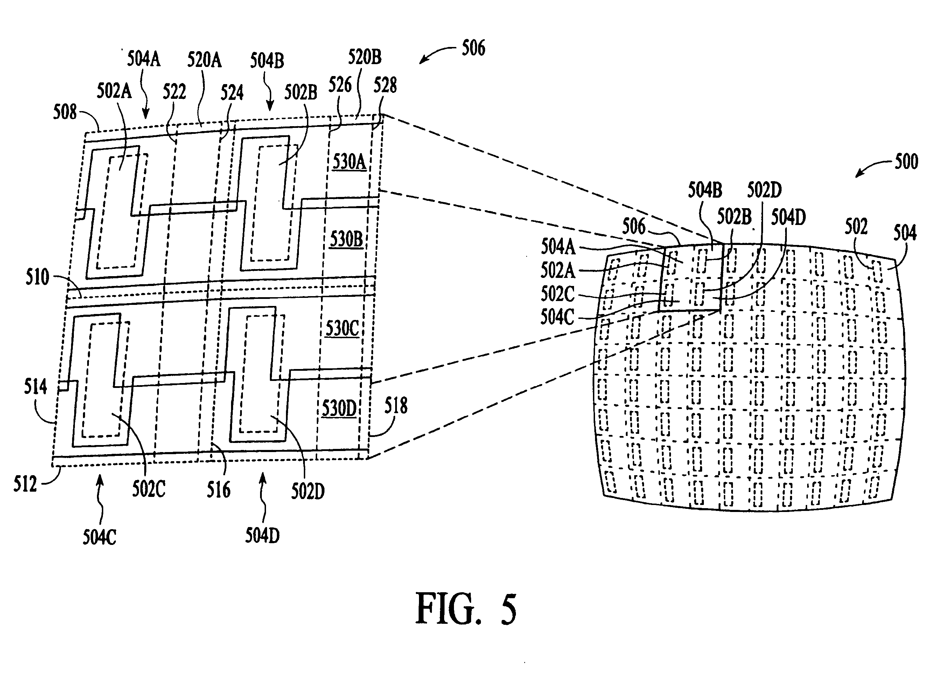

Turning now to Fig. 5, a CCD image sensor array 500 in accordance with a second exemplary embodiment of the invention is shown. The image sensor array 500 includes the same elements as the image sensor array 300 of Fig. 3. Thus, the image sensor array 500 includes photosensitive elements 502 within pixel regions 504, which are defined by intersecting horizontal and vertical curved lines. Similar to Fig. 3, a section 506 of the image sensor array 500 is shown enlarged to more clearly illustrate the configuration of the individual pixel regions 504 of the image sensor array. The enlarged section 506 includes four exemplary pixel regions 504A, 5048, 504C and 504D of the image sensor array 500 that are defined by horizontally orientated curved lines 508, 510 and 512 and vertically orientated curved lines 514, 516 and 518. The exemplary pixel regions 504A, 504B, 504C and 504D include photosensitive elements 502A, 502B, 502C and 502D, respectively.

Similar to the CCD image sensor array 300, the CCD image sensor array 500 includes vertically orientated CCD channels and horizontally orientated electrodes, which are illustrated by exemplary CCD channels 520A and 520B and exemplary electrodes 530A, 530B, 530C and 530D. The CCD channel 520A is defined by horizontally orientated edges 522 and 524, while the CCD channel 520B is defined by horizontally orientated edges 526 and 528.

In contrast to the image sensor array 300, the edges that define the photosensitive elements 502, the vertical CCD channels and the electrodes of the image sensor array 500 are not curved in a continuous fashion. Instead, these edges of the image sensor array 500 approximate corresponding curved lines of the image sensor array 300 using straight line segments. Thus, the image sensor array 500 is virtually identical to the image sensor array 300, except that the continuous curved edges of the photosensitive elements 302, the vertical CCD channels and the electrodes of the image sensor array 300 of Fig. 3 are replaced with one or more straight line segments, which approximate the corresponding continuous curved edges.

The edges of the photosensitive elements 502, the CCD channels and the electrodes of the image sensor array 500 that are shorter than a predefined length, for example, the width of a standard pixel region, are each replaced with a single straight line segment. Thus, each of the vertically and horizontally orientated edges of the photosensitive elements 502 is a single straight line segment that approximates the corresponding curved edge in the image sensor array 300 of Fig. 3. Consequently, many of the photosensitive elements 502 are configured as non-rectangular quadrilaterals. Therefore, much of the photosensitive elements 502 have one or more non-perpendicular angles. Similarly, each of the vertically orientated edges of the electrodes of the image sensor array 500 is replaced with a single straight line segment that approximates the corresponding curved edge in the image sensor array 300.

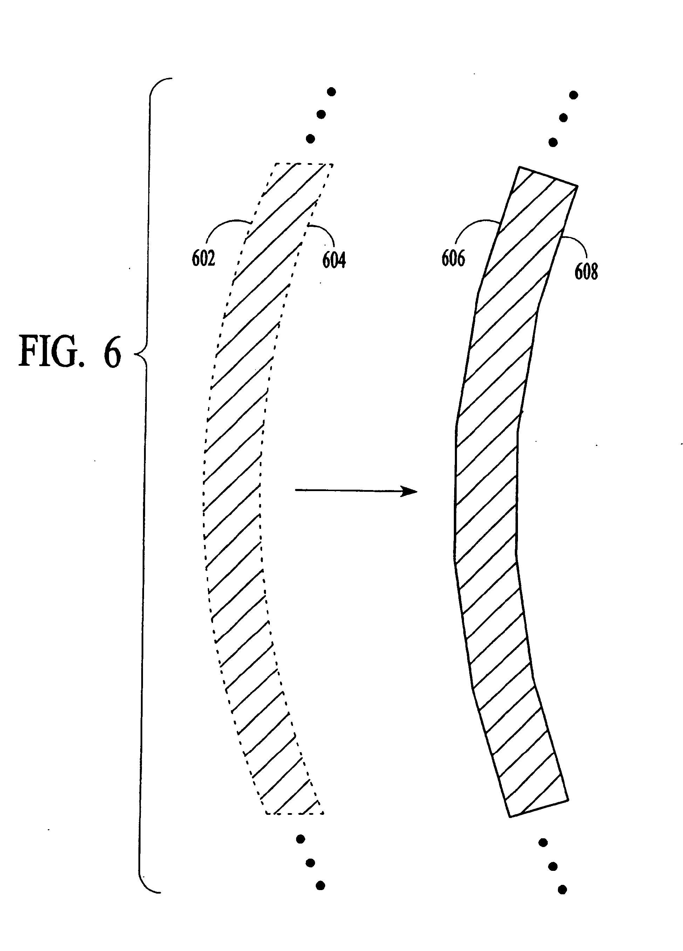

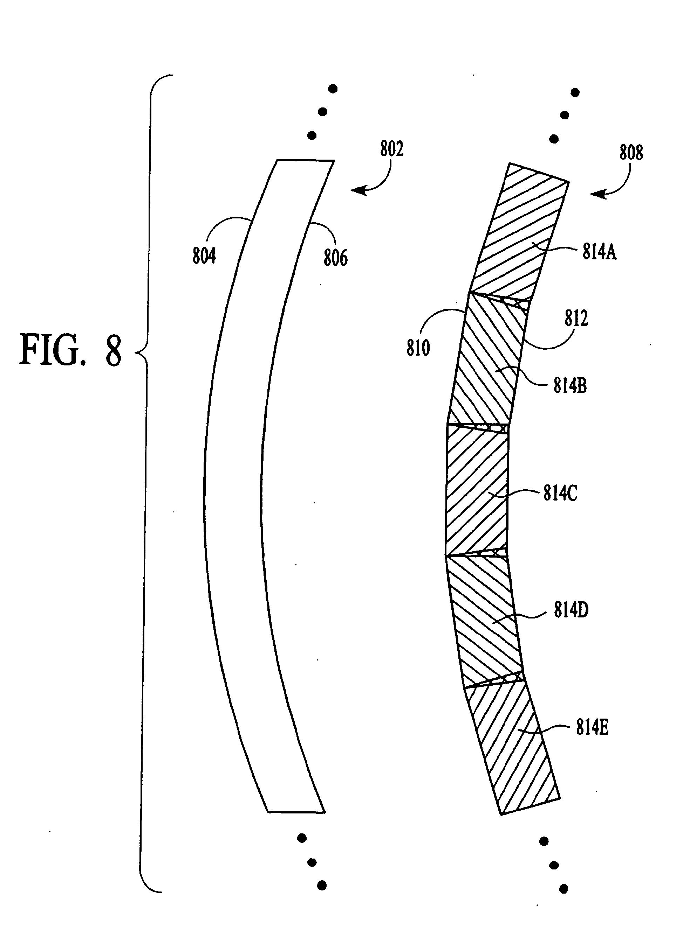

However, the edges of the image sensor array 500 that are longer than the predefined length, such as the vertically orientated edges of the CCD channels, are each replaced with a number of straight line segments that approximate the corresponding curved edge of the image sensor array 300 of Fig. 3. The use of multiple straight line segments to approximate curved edges is illustrate in Fig. 6. The curved dotted lines 602 and 604 in Fig. 8 represent vertically orientated edges of a CCD channel of the image sensor array 300. The solid lines 606 and 608 in Fig. 8, which are formed by multiple straight line segments, represent edges of a corresponding CCD channel of the image sensor array 500. As shown in Fig. 6, the multiple straight line segments of the solid lines 606 and 608 trace the corresponding curved dotted lines 602 and 604. Thus, the multiple straight line segments of the solid lines 606 and 608 approximate the curved dotted lines 602 and 604.

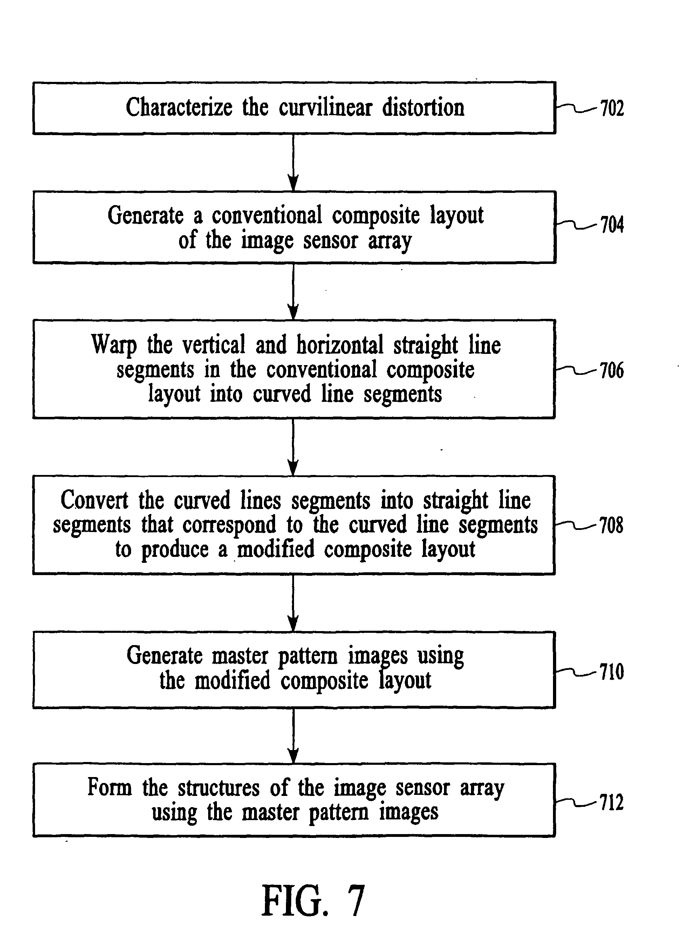

A method for fabricating the CCD image sensor array 500, which is designed to correct for curvilinear distortion of the associated lens system, in accordance with the invention is described with reference to Fig. 7. At step 702, the curvilinear distortion of the associated lens system is characterized so that the image sensor array can be designed to compensate for the distortion. At step 704, a conventional composite layout of the image sensor array is generated as input pattern data using known computer-assisted design (CAD) software. The conventional composite layout is a multi-level representation of various structures of the image sensor array to be fabricated, such as the photosensitive elements 502A, 502B, 502C and 502D, the electrodes 530A, 530B, 530C and 530D, and the CCD channels 520A and 520B. However, in the conventional composite layout, the structures of the image sensor array are configured as having vertical and horizontal straight line segments. As a result, the structures of the image sensor array in the conventional composite layout are defined by geometrical configurations having right angle comers. Consequently, the photosensitive elements 502 are rectangularly shaped. Furthermore, in the conventional composite layout, the photosensitive elements are not distributed in a non-uniform pattern to correct for the curvilinear distortion, as illustrated by the photosensitive elements 102 of the solid state image sensor array 100 in Fig. 1.

Next, the conventional composite layout is modified to generate a modified composite layout such that the structures of the image sensor array are configured as having straight line segments that are orientated to approximate the curvature of the curvilinear distortion, as illustrated in Fig. 5. The modification of the conventional composite layout is achieved by manipulating the input pattern data using appropriate software that utilizes the characterization of the curvilinear distortion to produce the straight line segments. At step 706, the vertical and horizontal straight line segments in the conventional composite layout are warped into curved line segments that correspond to the curvature of the curvilinear distortion. If the curvilinear distortion is associated with barrel distortion, then the vertical and horizontal straight line segments are warped in the same manner as the curved line segments that define the pixel regions 304 in the image sensor array 300 of Fig. 3. However, if the curvilinear distortion is associated with another type of distortion, then the vertical and horizontal straight line segments are warped in a manner that correspond to that specific distortion. At step 708, the curved line segments are then converted into one or more straight line segments that approximate the corresponding curved line segments using a pattern generator, which results in a modified composite layout that resembles the image sensor array 500 in Fig. 5.

If a typical pattern generator is used, then the warped features of the composite layout, which are defined by the curved line segments, are filled in using a number of appropriately sized rectangles to generate the modified composite layout. For example, as illustrated in Fig. 8, a vertically orientated CCD channel can be converted from a warped feature 802 defined by curved line segments 804 and 806 to an approximated feature 808 defined by multiple straight line segments 810 and 812. The pattern generator performs the conversion by filling in the warped feature 802 with a number of rectangles, e.g., rectangles 816A, 816B, 816C, 816D and 816E. As illustrated in Fig. 8, the rectangles may overlap with each other as the curved feature is filled in with the rectangles. However, since only the outline of these rectangles are used by the pattern generator to convert the warped feature 802 of the vertically orientated CCD channel into the approximated feature 808, the overlapping of the rectangles during the conversion is allowed. In a similar manner, other warped features of the composite layout such as the photosensitive elements are converted into corresponding approximated features using rectangles of various sizes to fill in the warped features to generate the modified composite layout.

Next, at step 710, master pattern images in the form of photomasks or reticles are generated using the modified composite layout. Thus, the edges of structures in the master pattern images are formed by one or more straight line segments. At step 712, using the master pattern images, various structures of the image sensor array are then formed on a semiconductor wafer in a conventional high-volume fabrication process.

The solid state image sensor arrays described and illustrated herein are CCD sensor arrays having a particular configuration. However, the modifications used to produce the image sensor arrays in accordance with the invention may also be used to modify CCD sensor arrays having different configurations and other types of solid state image sensor arrays, such as complementary metal oxide semiconductor (CMOS) sensor arrays.

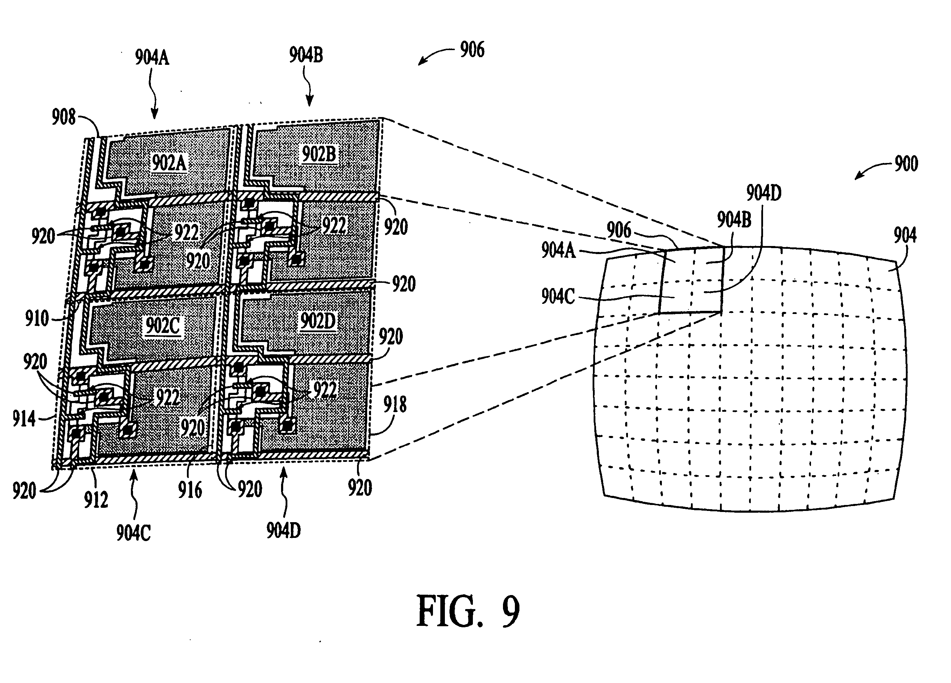

In Fig. 9, an exemplary CMOS sensor array 900 that has been modified in accordance with the invention is shown. Similar to the CCD sensor array 500 of Fig. 5, the CMOS sensor array is configured to compensate for a barrel-type curvilinear distortion. Consequently, the CMOS sensor array includes pixel regions 904 that are distributed in a non-uniform pattern, as illustrated in Fig. 9. An enlarged section 906 of the CMOS sensor array is shown in Fig. 9 to illustrate the configuration of the individual pixel regions 904. The enlarged section includes four exemplary pixel regions 904A, 904B, 904C and 904D that are defined by horizontally orientated curved lines 908, 910 and 912 and vertically orientated curved lines 914, 916 and 918. The exemplary pixel regions 904A, 904B, 904C and 904D include photosensitive elements 902A, 902B, 902C and 902D. In contrast to the photosensitive elements 502 of the CCD sensor array, the photosensitive elements of the CMOS sensor array are polygonal in shape, as illustrated by the photosensitive elements 902A, 902B, 902C and 902D.

As shown in the enlarged section 906, the exemplary pixel regions 904A, 904B, 904C and 904D includes various metallization strips 920 that provides electrical connections to the photosensitive elements 902A, 902B, 902C and 902D and field-effect transistors (FETs) 922. In conventional CMOS sensor arrays, the photosensitive elements and metallization strips are defined by horizontal and vertical straight line segments. Consequently, the conventional photosensitive elements and metallization strips include orthogonal comers. However, in the CMOS sensor array 900, the photosensitive elements and metallization strips have been modified in the manner described herein. Thus, the metallization conductive strips are modified to conform to the curvature of the curvilinear distortion using multiple straight line segments. In addition, the polygonal photosensitive elements are modified using straight line segments that are rotated to approximate the curvature of the curvilinear distortion, thereby producing many polygonal photosensitive elements with one or more non-perpendicular comers.

Although specific embodiments of the invention have been described and illustrated, the invention is not to be limited to the specific forms or arrangements of parts so described and illustrated. The scope of the invention is to be defined by the claims appended hereto and their equivalents.

## Claims

1. An image sensor array (300; 500; 900) for correcting a curvilinear distortion comprising:
an array of photosensitive elements (302; 502; 902A, 902B, 902C, 902D), the photosensitive elements being distributed in a nonuniform pattern that compensates for the curvilinear distortion, **characterised by** some of the photosensitive elements of the image sensor array having a non-perpendicular corner.

2. The image sensor array (300; 500; 900) of claim 1 wherein some of the photosensitive elements (302; 502; 902A, 902B, 902C, 902D) are defined by curved line segments that correspond to the curvature of the curvilinear distortion.

3. The image sensor array (300; 500; 900) of claim 1 wherein some of the photosensitive elements (302; 502; 902A, 902B, 902C, 902D) are defined by straight line segments that form polygonal areas.

4. The image sensor array (300; 500; 900) of claim 1, 2 or 3 further comprising elongated structures (320A, 320B; 520A, 520B; 920) having edges that correspond to the curvature of the curvilinear distortion.

5. The image sensor array (300; 500; 900) of claim 4 wherein the edges of the elongated structures (320A, 320B; 520A, 520B; 920) are defined by multiple straight lines segments (606, 608) that approximate the curvature of the curvilinear distortion.

6. A method of fabricating an image sensor array (300; 500; 900) of photosensitive elements (302;502;902A,902B,902C,902D) designed to correct for a curvilinear distortion comprising:
generating (702) an original composite layout of the image sensor array, the original composite layout including straight line segments that define photosensitive elements of the image sensor array;
transforming (706, 708) the original composite layout into a modified composite layout, including warping (706) the straight line segments into curved line segments that correspond to the curvature of the curvilinear distortion; and
forming (712) the photosensitive elements of the image sensor array using the modified composite layout to fabricate the image sensor array so that some of the photosensitive elements have a non perpendicular corner.

7. The method of claim 6 wherein the step of transforming (706, 708) the original composite layout into the modified composite layout includes converting (708) the curved line segments of the photosensitive elements into replacement straight line segments that approximate the orientations of the curved line segments.

8. The method of claim 7 wherein the step of converting (708) the curved line segments of the photosensitive elements into the replacement straight line segments includes converting some of the curved line segments into single straight line segments that are orientated to conform to the converted curved line segments.

9. The method of claim 8 wherein the step of converting some of the curved line segments into the single straight line segments includes converting the curved line segments that define the photosensitive elements (302; 502; 902A, 902B, 902C, 902D) of the image sensor array (300; 500; 900) into sets of straight line segments that form polygonal areas, some of the polygonal areas having a non-perpendicular corner.

10. The method of claim 7, 8 or 9 wherein the step of converting (708) the curved line segments of the photosensitive elements into the replacement straight line segments includes converting some of the curved line segments into multiple straight line segments (606, 608) that substantially trace the converted curved line segments.

## Patentansprüche

1. Ein Bildsensorarray (300; 500; 900) zum Korrigieren einer krummlinigen Verzerrung, das folgende Merkmale aufweist:
ein Array von lichtempfindlichen Elementen (302; 502; 902A, 902B, 902C, 902D), wobei die lichtempfindlichen Elemente in einem nicht-gleichmäßigen Muster verteilt sind, das die krummlinige Verzerrung kompensiert, **dadurch gekennzeichnet, dass** manche der lichtempfindlichen Elemente des Bildsensorarrays eine nicht-senkrechte Ecke aufweisen.

2. Das Bildsensorarray (300; 500; 900) gemäß Anspruch 1, bei dem manche der lichtempfindlichen Elemente (302; 502; 902A, 902B, 902C, 902D) durch bogenlinige Segmente definiert sind, die der Krümmung der krummlinigen Verzerrung entsprechen.

3. Das Bildsensorarray (300; 500; 900) gemäß Anspruch 1, bei dem manche der lichtempfindlichen Elemente (302; 502; 902A, 902B, 902C, 902D) durch geradlinige Segmente definiert sind, die polygonale Bereiche bilden.

4. Das Bildsensorarray (300; 500; 900) gemäß Anspruch 1, 2 oder 3, das ferner längliche Strukturen (320A, 320B; 520A, 520B; 920) aufweist, die Ränder aufweisen, die der Krümmung der krummlinigen Verzerrung entsprechen.

5. Das Bildsensorarray (300; 500; 900) gemäß Anspruch 4, bei dem die Ränder der länglichen Strukturen (320A, 320B; 520A, 520B; 920) durch mehrere geradlinige Segmente (606, 608) definiert sind, die sich an die Krümmung der krummlinigen Verzerrung annähern.

6. Ein Verfahren zum Herstellen eines Bildsensorarrays (300; 500; 900) von lichtempfindlichen Elementen (302; 502; 902A, 902B, 902C, 902D), das dahin gehend entworfen ist, eine krummlinige Verzerrung zu korrigieren, wobei das Verfahren folgende Schritte umfasst:
Erzeugen (702) einer ursprünglichen Verbundanordnung des Bildsensorarrays, wobei die ursprüngliche Verbundanordnung geradlinige Segmente umfasst, die lichtempfindliche Elemente des Bildsensorarrays definieren;
Transformieren (706, 708) der ursprünglichen Verbundanordnung in eine modifizierte Verbundanordnung, einschließlich eines Verformens (706) der geradlinigen Segmente in bogenlinige Segmente, die der Krümmung der krummlinigen Verzerrung entsprechen; und
Bilden (712) der lichtempfindlichen Elemente des Bildsensorarrays unter Verwendung der modifizierten Verbundanordnung, um das Bildsensorarray herzustellen, so dass manche der lichtempfindlichen Elemente eine nicht-senkrechte Ecke aufweisen.

7. Das Verfahren gemäß Anspruch 6, bei dem der Schritt des Transformierens (706, 708) der ursprünglichen Verbundanordnung in die modifizierte Verbundanordnung ein Umwandeln (708) der bogenlinigen Segmente der lichtempfindlichen Elemente in geradlinige Ersatzsegmente, die sich an die Orientierungen der bogenlinigen Segmente annähern, umfasst.

8. Das Verfahren gemäß Anspruch 7, bei dem der Schritt des Umwandelns (708) der bogenlinigen Segmente der lichtempfindlichen Elemente in die geradlinigen Ersatzsegmente ein Umwandeln mancher der bogenlinigen Segmente in einzelne geradlinige Segmente, die dahin gehend orientiert sind, zu den umgewandelten bogenlinigen Segmenten passen, umfasst.

9. Das Verfahren gemäß Anspruch 8, bei dem der Schritt des Umwandelns mancher der bogenlinigen Segmente in die einzelnen geradlinigen Segmente ein Umwandeln der bogenlinigen Segmente, die die lichtempfindlichen Elemente (302; 502; 902A, 902B, 902C, 902D) des Bildsensorarrays (300; 500; 900) definieren, in Sätze von geradlinigen Segmenten, die polygonale Bereiche bilden, umfasst, wobei manche der polygonalen Bereiche eine nicht-senkrechte Ecke aufweisen.

10. Das Verfahren gemäß Anspruch 7, 8 oder 9, bei dem der Schritt des Umwandelns (708) der bogenlinigen Segmente der lichtempfindlichen Elemente in die geradlinigen Ersatzsegmente ein Umwandeln mancher der bogenlinigen Segmente in mehrere geradlinige Segmente (606, 608), die die umgewandelten bogenlinigen Segmente im Wesentlichen nachverfolgen, umfasst.

## Revendications

1. Réseau de capteurs d'image (300, 500, 900) en vue de corriger une distorsion curviligne comportant :
■ un réseau d'éléments photosensibles (302 ; 502 ; 902A ; 902B ; 902C ; 902D), les éléments photosensibles étant distribués dans un schéma non uniforme qui compense la distorsion curviligne, **caractérisé en ce que** certains des éléments photosensibles du réseau de capteurs d'image ont un angle non perpendiculaire.

2. Réseau de capteurs d'image (300, 500, 900) selon la revendication 1, dans lequel certains des éléments photosensibles (302 ; 502 ; 902A ; 902B ; 902C ; 902D) sont définis par des segments de ligne courbes qui correspondent à la courbure de la distorsion curviligne.

3. Réseau de capteurs d'image (300, 500, 900) selon la revendication 1, dans lequel certains des éléments photosensibles (302 ; 502 ; 902A ; 902B ; 902C ; 902D) sont définis par des segments de ligne rectilignes qui forment des zones polygonales.

4. Réseau de capteurs d'image (300, 500, 900) selon la revendication 1, 2 ou 3 comportant en outre des structures allongées (320A ; 320B ; 520A ; 520B ; 920) ayant des arêtes qui correspondent à la courbure de la distorsion curviligne.

5. Réseau de capteurs d'image (300, 500, 900) selon la revendication 4 dans lequel les arêtes des structures allongées (320A ; 320B ; 520A ; 520B ; 920) sont définies par des segments de ligne rectilignes multiples (606, 608) qui adoucissent la courbure de la distorsion curviligne.

6. Procédé de fabrication d'un réseau de capteurs d'image (300 ; 500 ; 900) d'éléments photosensibles (302 ; 502 ; 902A ; 902B ; 902C ; 902D) conçu en vue de corriger une distorsion curviligne comportant les étapes consistant à :
■ générer (702) un agencement composite initial du réseau de capteurs d'image, l'agencement composite initial incluant des segments de ligne rectilignes qui définissent des éléments photosensibles du réseau de capteurs d'image ;
■ transformer (706, 708) l'agencement composite initial en un agencement composite modifié, comportant l'étape consistant à gauchir (706) les segments de ligne rectilignes en segments de ligne courbes qui correspondent à la courbure de la distorsion curviligne ; et
■ former (712) les éléments photosensibles du réseau de capteurs d'image au moyen de l'agencement composite modifié en vue de fabriquer le réseau de capteurs d'image de sorte que certains des éléments photosensibles aient un angle non perpendiculaire.

7. Procédé selon la revendication 6 dans lequel les étapes de transformation (706, 708) de l'agencement composite initial en agencement composite modifié comportent l'étape consistant à convertir (708) les segments de ligne courbes des éléments photosensibles en segments de ligne rectilignes de remplacement qui adoucissent les orientations des segments de ligne courbes.

8. Procédé selon la revendication 7 dans lequel l'étape de conversion (708) des segments de ligne courbes des éléments photosensibles en segments de ligne rectilignes de remplacement comporte l'étape consistant à convertir certains des segments de ligne courbes en segments de ligne rectilignes uniques qui sont orientés en vue de se conformer aux segments de ligne courbes.

9. Procédé selon la revendication 8 dans lequel l'étape de conversion (708) de certains des segments de ligne courbes en segments de ligne rectilignes uniques comporte l'étape consistant à convertir les segments de ligne courbes qui définissent les éléments photosensibles (302 ; 502 ; 902A ; 902B ; 902C ; 902D) du réseau de capteurs d'image (300 ; 500 ; 900) en jeux de segments de ligne rectilignes qui forment des zones polygonales, certaines des zones polygonales ayant un angle non perpendiculaire.

10. Procédé selon la revendication 7, 8 ou 9 dans lequel l'étape de conversion (708) des segments de ligne courbes des éléments photosensibles en segments de ligne rectilignes de remplacement comporte l'étape consistant à convertir certains des segments de ligne courbes en segments de ligne rectilignes multiples (606, 608) qui tracent sensiblement les segments de ligne courbes convertis.
